# EUROPEAN PATENT APPLICATION

(11) **EP 2 568 060 A2**
(43) Date of publication of application: **13.03.2013**
(21) Application number: 12790781.4
(22) Date of filing: 22.05.2012
(51) Int. Cl.: C23C 14/24, C23C 14/56

(54) **FUEL SUPPLY UNIT FOR A THIN FILM DEPOSITION APPARATUS**

(30) Priority: 31.05.2011 KR 20110052458
(71) Applicant: SNU Precision Co., Ltd., Seoul 152-818 (KR)
(72) Inventor: KONG, Doo Won, Seoul 158-848 (KR); PARK, Sang Hyun, Asan-si Chungcheongnam-do 336-719 (KR); KWON, Jin Hwan, Cheonan-si Chungcheongnam-do 331-964 (KR); CHA, Jea Jung, Yongin-si Gyeonggi-do 446-922 (KR); PARK, Byoung Min, Namyangju-si Gyeonggi-do 472-831 (KR); LEE, Young Kuk, Seoul 152-792 (KR)
(74) Representative: Ahmad, Sheikh Shakeel
(86) International application number: PCT/KR2012/004026
(87) International publication number: WO 2012/165793

(57) **Abstract**

Disclosed is a source material supplying unit for a thin film depositing apparatus, arranged in a chamber for the thin film deposition apparatus and supplying an evaporation material to an injector for injecting the evaporation material, the source material supplying unit including: a container body which is internally formed with a storage space where the evaporation material is stored, and includes a discharging hole formed at one side thereof connected to the injector via a connection line; a transfer member which includes a piston body inserted in the storage space of the container body movably along a straight line, two or more seating members formed with a seating portion on an outer circumferential surface and arranged on an outside surface of the piston body, and at least two contact rings assembled to the seating portion of the seating member and closely contacting the inner circumferential surface of the storage space of the container body; and a pressing member which applies pressure to the transfer member so that the transfer member can move toward the discharging hole of the container body.

## Description

### [Technical Field]

The present invention relates to a source material supplying unit for a thin film depositing apparatus, and more particularly to a source material supplying unit for a thin film depositing apparatus, in which two or more contact rings are in contact with an inner wall surface of a container body, thereby improving a shielding effect and allowing the position and number of such contact rings to be selectively adjusted.

### [Background Art]

The solar cell is a semiconductor device that uses a photovoltaic effect to convert light energy into electric energy, which has recently attracted attention as fossil fuel runs out. Particularly, a copper indium gallium selenide (CIGS) thin film solar cell or cadmium telluride (CDTE) solar cell, or the like compound thin film solar cell has attracted attention as a next-generation solar cell since it is manufactured by a relatively simple process, has a low production cost, and gets light-conversion efficiency raised up to that of the existing solar cell.

Also, an organic light emitted diode (OLED) is capable of emitting light by itself on the contrary to a liquid crystal display (LCD) device, and thus has no need of a backlight, thereby having low power consumption. Further, the OLED has a vide view angle and a quick response, so that a display device using the same can display a good image without problems of a view angle and an afterimage.

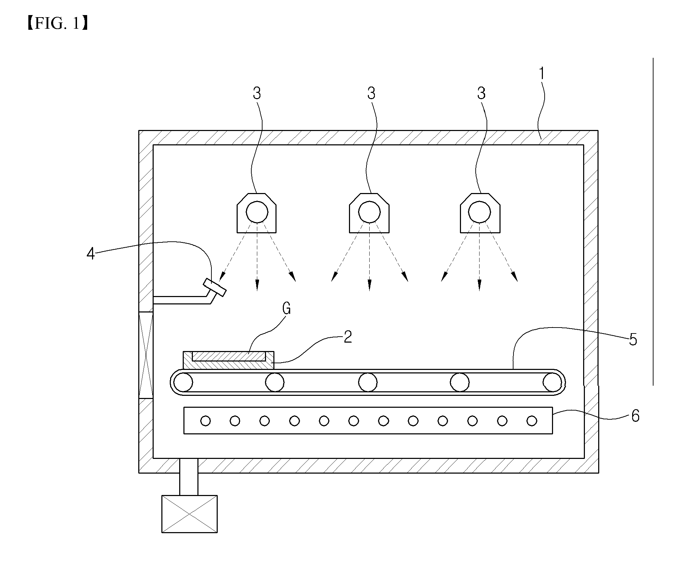

Meanwhile, a vacuum thermal deposition method has been generally employed as a deposition process applied when manufacturing the solar cell and the OLED. Such a conventional thin film deposition apparatus as shown in Fig. 1 includes a chamber 1, a substrate supporter 2 provided in the chamber 1 and supporting a substrate G, a source material supplying unit 3 arranged opposite to the substrate G and supplying a source material to the substrate G, a film thickness sensor (crystal sensor) 4 measuring thickness of a thin film deposited on the substrate G, a substrate moving member 5 transferring the substrate supporter 2, and a temperature control means 6 controlling and maintaining temperature adapted for depositing the substrate.

If the vacuum thermal deposition method is used to manufacture a flat panel display device or a solar cell device, an evaporation source has to be applicable to a large-sized substrate, have controllable speed for stable deposition, and large capacity for continuously supplying evaporation materials.

However, the evaporation source used in the conventional deposition apparatus has a problem of often stopping the operation of the apparatus since its crucible has a limited filling capacity. To solve this problem, a method of increasing the filling capacity for a deposition material has been proposed, but this method needs more quantity of heat to evaporate the deposition material by heating the enlarged crucible. Further, it is difficult to control deposition speed and keep deposition quality because a large amount of deposition material is evaporated and injected. If various deposition materials are used, it is further difficult to control the deposition speed and keep the deposition quality. Therefore, a thin film that has to be uniformly formed on the surface of the film thickness sensor is non-uniformly formed, and thus a replacement cycle becomes shorter, thereby having a problem of frequently stopping the operation of the apparatus, and causing inconvenience in applying a tooling factor in accordance with the kinds of deposition materials and the positions of the film thickness sensor.

### [Disclosure]

### [Technical Problem]

Accordingly, the present invention is conceived to solve the forgoing problems, and an aspect of the present invention is to provide a source material supplying unit for a thin film depositing apparatus, in which two or more contact rings are in contact with an inner wall surface of a container body, so that a shielding effect can be improved and the position and number of such contact rings can be selectively adjusted, thereby extending an applicable range of the apparatus in accordance with characteristics of the evaporation member.

Also, an aspect of the present invention is to provide a source material supplying unit for a thin film depositing apparatus, in which a guiding ring is arranged between two or more contact rings in order to keep a gap between the contact rings, thereby preventing a transfer member from swerving.

Also, an aspect of the present invention is to provide a source material supplying unit for a thin film depositing apparatus, in which if one among contact rings is worn away due to repetitive use, it is possible to replace only relevant elements, thereby reducing maintenance costs.

Also, an aspect of the present invention is to provide a source material supplying unit for a thin film depositing apparatus, in which two or more contact rings are in contact with an inner circumferential surface of a container body while being spaced from each other, so that a shielding effect can be secured and a transfer member can be easily separated from the container body for maintenance.

### [Technical Solution]

One aspect of the present invention provides a source material supplying unit for a thin film depositing apparatus, arranged in a chamber for the thin film deposition apparatus and supplying an evaporation material to an injector for injecting the evaporation material, the source material supplying unit including: a container body which is internally formed with a storage space where the evaporation material is stored, and includes a discharging hole formed at one side thereof connected to the injector via a connection line; a transfer member which includes a piston body inserted in the storage space of the container body movably along a straight line, two or more seating members formed with a seating portion on an outer circumferential surface and arranged on an outside surface of the piston body, and at least two contact rings assembled to the seating portion of the seating member and closely contacting the inner circumferential surface of the storage space of the container body; and a pressing member which applies pressure to the transfer member so that the transfer member can move toward the discharging hole of the container body.

The transfer member may further include a guide ring arranged between the two contact rings and keeping a gap between the contact rings.

The guide ring may be assembled to the seating portion of the seating member additionally arranged between the seating members to which the two contact rings are assembled.

The seating member may include the seating portion on the upper end portion of the outer circumferential surface, and a holding projection protruding from the lower end portion of the outer circumferential surface.

The bottommost seating member among the two or more seating members arranged on an outside surface of the piston body may be fastened to the piston body.

The transfer member may further include a fastening member penetrating the two or more seating members and fastened to the piston body.

The transfer member may further include a cover ring formed with a plurality of through holes on a surface thereof which the fastening member penetrates, and arranged above the topmost seating member among the two or more seating members

The transfer member may further includes a connection member arranged in a central upside of the piston body and detachably coupling with the pressing member.

### [Advantageous Effects]

According to an exemplary embodiment, there is provided a source material supplying unit for a thin film depositing apparatus, in which two or more contact rings are in contact with an inner wall surface of a container body, so that a shielding effect can be improved and the position and number of such contact rings can be selectively adjusted, thereby extending an applicable range of the apparatus in accordance with characteristics of the evaporation member.

According to an exemplary embodiment, there is provided a source material supplying unit for a thin film depositing apparatus, in which a guiding ring is arranged between two or more contact rings in order to keep a gap between the contact rings, thereby preventing a transfer member from swerving.

According to an exemplary embodiment, there is provided a source material supplying unit for a thin film depositing apparatus, in which if one among contact rings is worn away due to repetitive use, it is possible to replace only relevant elements, thereby reducing maintenance costs.

According to an exemplary embodiment, there is provided a source material supplying unit for a thin film depositing apparatus, in which two or more contact rings are in contact with an inner circumferential surface of a container body while being spaced from each other, so that a shielding effect can be secured and a transfer member can be easily separated from the container body for maintenance.

### [Description of Drawing]

Fig. 1 shows a schematic configuration of a conventional thin film deposition apparatus,
Fig. 2 shows a schematic structure of a source material supplying unit for a thin film depositing apparatus according to an embodiment of the present invention,
Fig. 3 is a perspective view of a transfer member of the source material supplying unit for the thin film depositing apparatus according to an embodiment of the present invention,
Fig. 4 is an exploded perspective view of the transfer member of the source material supplying unit for the thin film depositing apparatus according to an embodiment of the present invention,
Fig. 5 is a cross-section view of the source material supplying unit for the thin film depositing apparatus according to an embodiment of the present invention, and
Fig. 6 is a partially enlarged cross-section view of the transfer member of the source material supplying unit for the thin film depositing apparatus according to an embodiment of the present invention

### [Best Mode]

Prior to description, like numerals will refer to like elements through many exemplary embodiments, which are representatively described in an exemplary embodiment, and the other exemplary embodiments describe only different configurations.

Below, a source material supplying unit for a thin film depositing apparatus according to an exemplary embodiment of the present invention will be described with reference to accompanying drawings.

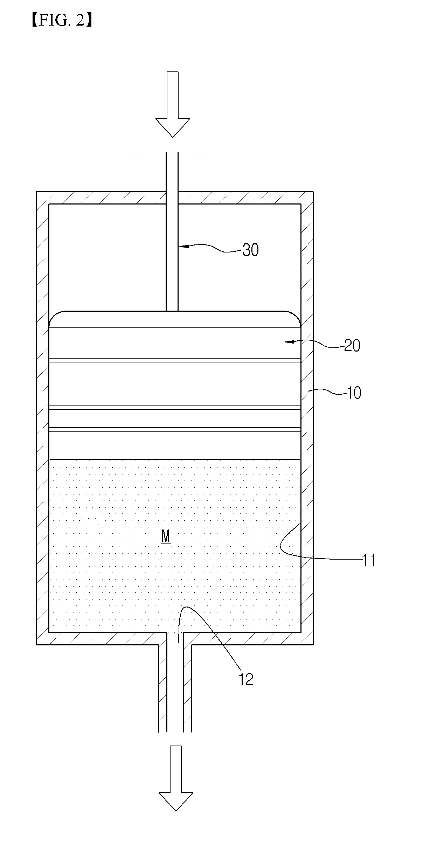

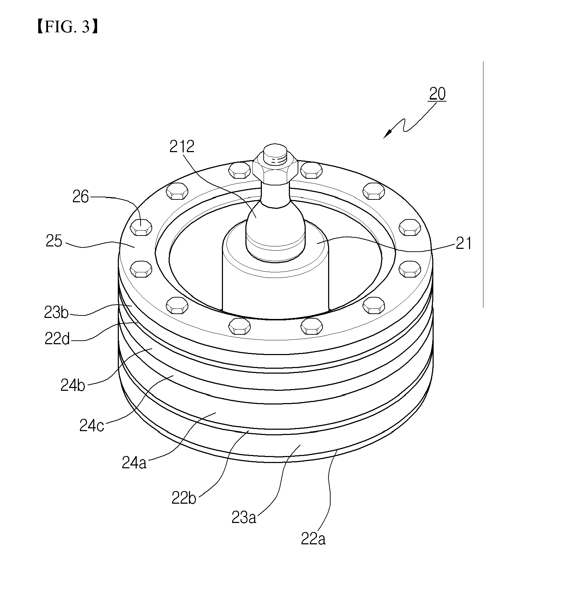

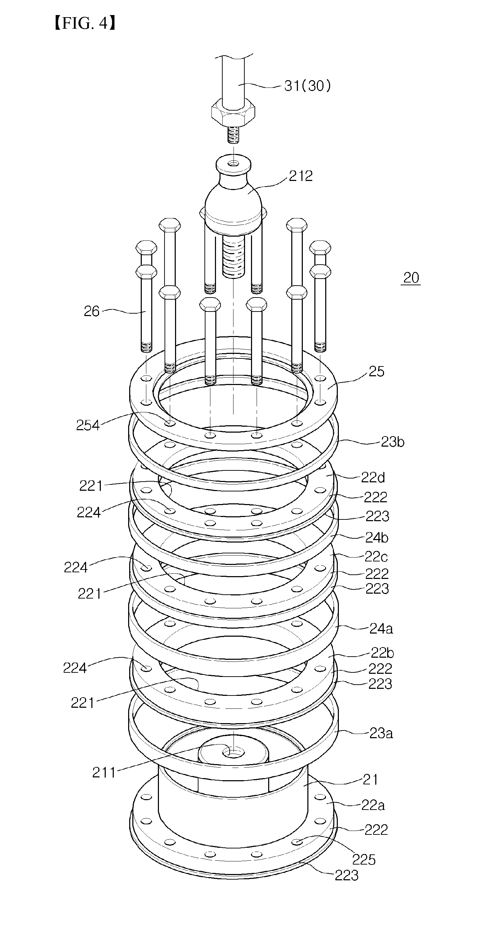

Fig. 2 shows a schematic structure of a source material supplying unit for a thin film depositing apparatus according to an embodiment of the present invention, Fig. 3 is a perspective view of a transfer member extracted from the source material supplying unit for the thin film depositing apparatus according to an embodiment of the present invention, and Fig. 4 is an exploded perspective view of the transfer member of the source material supplying unit for the thin film depositing apparatus according to an embodiment of the present invention,

As shown therein, the source material supplying unit for the thin film deposition apparatus according to an embodiment of the present invention is arranged inside a chamber for the thin film deposition apparatus and supplies an evaporation material M to the injector that injects the evaporation material M. The source material supplying unit includes a container body 10, a transfer member 20 and a pressing member 30

The container body 10 is shaped like a cylinder internally formed with a storage space 11 where the evaporation material M is stored, and formed with a discharging hole 12 at one side thereof to be connected to the injector through a connection lin.

The transfer member 20 includes a piston body 21, a seating member, a contact ring, a guide ring, a cover ring 25, a connection member 212 and the fastening member 26. In this embodiment, there are four seating member, two contact rings and two guide rings by way of an example, which will be described as a first seating member 22a, a second seating member 22b, a third seating member 22c and a fourth seating member 22d, a first contact ring 23a, a second contact ring 23b, a first guide ring 24a, and the second guide ring 24b for convenience of description.

The piston body 21 is inserted in the storage space 11 of the container body 10 movably along a straight line, and is formed with a second fastening hole 211 at an upper portion thereof.

The first seating member 22a includes a seating portion 222 and a holding projection 223 respectively formed at an upper end portion and a lower end portion of an outer circumferential surface, and includes a through hole 224 at an upper side thereof corresponding to a first fastening hole 225. Further, the first seating member 22a is arranged in the lower end portion of the outer circumferential surface of the piston body 21 and fastened to the piston body 21.

The second to fourth seating members 22b, 22c and 22d are formed with insertion holes 221 through the center of which the piston body 21 is inserted, and include the seating portion 222 and the holding projection 223 respectively formed at the upper and lower end portions of the outer circumferential surface, Further, The second to fourth seating members 22b, 22c and 22d include through holes 224 at the upper side thereof corresponding to the first fastening hole 225 and are stacked in sequence on the first seating member 22a.

The first contact ring 23a and the second contact ring 23b are assembled so that the inner circumferential surfaces thereof can closely contact the seating portions 222 of the first seating member 22a and the fourth seating member 22d, respectively. Further, the outer circumferential surfaces of the first contact ring 23a and the second contact ring 23b closely contact the inner circumferential surface of the storage space 11 of the container body 10.

The inner circumferential surfaces of the first guide ring 24a and the second guide ring 24b are inserted in the seating portions 222 of the second seating member 22b and the third seating member 22c, respectively.

The cover ring 25 is arranged at an upper side of the fourth seating member 22d, and formed with a through hole 254 on a surface thereof corresponding to the first fastening hole 225.

The connection member 212 is arranged at a middle upside of the piston body 21 and fastened to the second fastening hole 211.

The fastening member 26 is fastened to the first fastening hole 225 of the first seating member 22a fastened to the piston body 21 via the through hole 254 of the cover ring 25 and the through holes 224 of the fourth seating member 22d, the third seating member 22c and the second seating member 22b, thereby maintaining the assembled state of the transfer member 20.

The pressing member 30 applies pressure so that the transfer member 20 can move toward the discharging hole 12 within the storage space 11 of the container body 10, and is formed with a piston rod 31 connected to the connection member 212 of the transfer member 20.

From now on, operations of the source material supplying unit for the thin film depositing apparatus will be described according to a first embodiment.

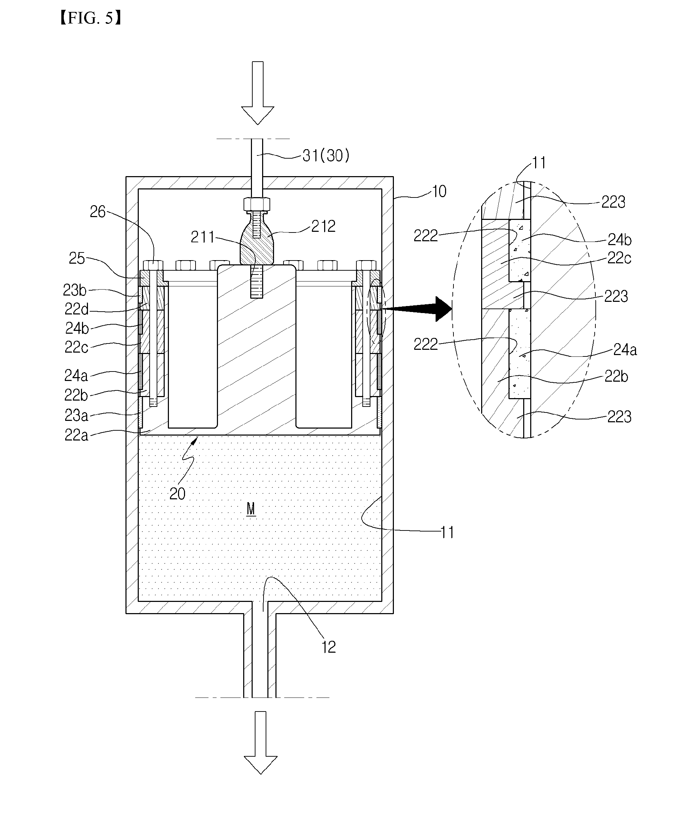

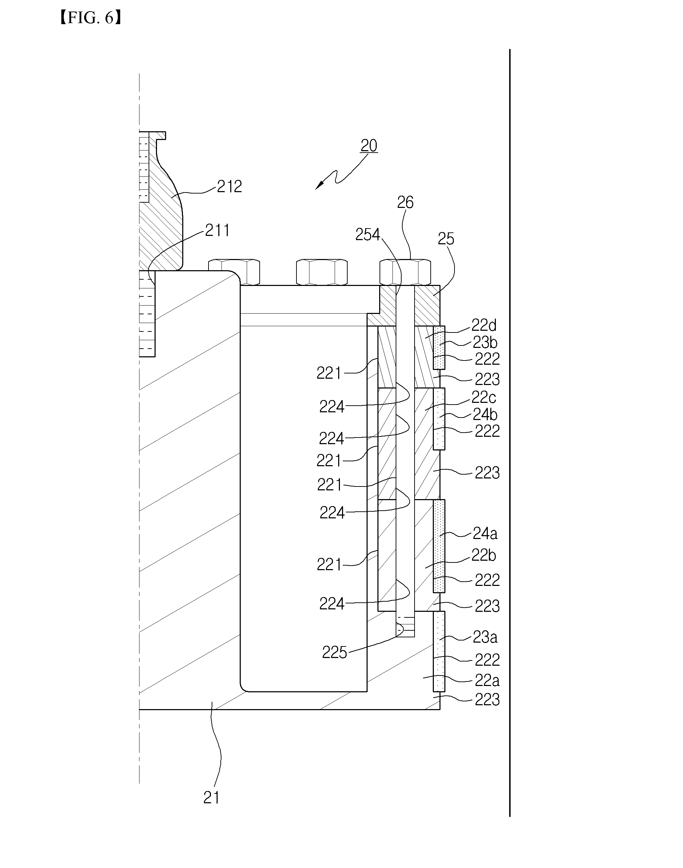

Fig. 5 is a cross-section view of the source material supplying unit for the thin film depositing apparatus according to an embodiment of the present invention, and Fig. 6 is a partially enlarged cross-section view of the transfer member of the source material supplying unit for the thin film depositing apparatus according to an embodiment of the present invention.

Fig. 5 is a cross-section view of the source material supplying unit for the thin film depositing apparatus according to an embodiment of the present invention, and Fig. 5 is a cross-section view of the transfer member of the source material supplying unit for the thin film depositing apparatus according to an embodiment of the present invention.

First, as shown in Fig. 4, the transfer member 20 is inserted in the storage space 11 of the container body 10 shaped like a cylinder, and the transfer member 20 is connected to the pressing member 30 and presses the evaporation material M filled in the storage space 11 to be discharged through the discharging hole 12 while moving toward the discharging hole 12 of the container body 10 by pressure applied from the pressing member 30

Here, the transfer member 20 is improved in a shielding effect since the first contact ring 23a and the second contact ring 23b arranged outside the piston body 21 are in close-contact with the inner circumferential surface of the container body 10.

Also, the first guide ring 24a and the second guide ring 24b are arranged between the first contact ring 23a and the second contact ring 23b, so that a gap between the first contact ring 23a and the second contact ring 23b can be kept to make axial movement of the transfer member 20 be stable. Also, the outer circumferential surfaces of the first guide ring 24a and the second guide ring 24b, together with the first contact ring 23a and the second contact ring 23b, are in close-contact with or are adjacent to the inner circumferential surface of the storage space 11 of the container body 10, thereby preventing the transfer member 20 from swerving while the transfer member 20 is moving within the storage space 11 of the container body 10.

Below, an assembling structure of the foregoing transfer member 20 will be described.

As shown in Fig. 6, in the state that the first seating member 22a is fastened to (or integrated with) the lower end portion of the outer circumferential surface of the piston body 21, if the first contact ring 23a is inserted in the seating portion 222 formed on the upper end portion of the outer circumferential surface of the first seating member 22a, an inserting position of the first contact ring 23a is guided by the holding projection 223 formed on the lower end portion of the outer circumferential surface of the first seating member 22a.

Then, the insertion hole 221 of the second seating member 22b is put on the outer circumferential surface of the piston body 21, so that the holding projection 223 formed on the lower end portion of the outer circumferential surface of the second seating member 22b supports the upper end portion of the first contact ring 23a.

Further, the first guide ring 24a is inserted in the seating portion 222 formed on the upper end portion of the outer circumferential surface of the second seating member 22b, the insertion hole 221 of the third seating member 22c is inserted in the outer circumferential surface of the piston body 21, and the second guide ring 24b is inserted in the seating portion 222 of the third seating member 22c.

Also, the insertion hole 221 of the fourth seating member 22d is put on the outer circumferential surface of the piston body 21 so that the fourth seating member 22d can be arranged above the third seating member 22c, and the second contact ring 23b is inserted in the seating portion 222 of the fourth seating member 22d. Then, if the cover ring 25 is arranged above the second contact ring 23b, the lower end portion of the outer circumferential surface of the cover ring 25 supports the upper end portion of the second contact ring 23b.

As described above, in the state that the second seating member 22b, the third seating member 22c, the fourth seating member 22d, the cover ring 25 are stacked in sequence above the first seating member 22a, the fastening member 26 penetrates the through hole 254 of the cover ring 25 and the through holes 224 of the fourth seating member 22d, the third seating member 22c and the second seating member 22b, and is then fastened to the first fastening hole 225 of the first seating member 22a, thereby completing assembly of the transfer member 20.

At this time, the first contact ring 23a, the first guide ring 24a and the second guide ring 24b are interposed between the holding projections 223 arranged up and down, and the second contact ring 23b is interposed between the holding projection 223 of the third seating member 22c and the lower end portion of the outer circumferential surface of the cover ring 25, thereby holding a position in up and down directions.

Also, the piston rod 31 of the pressing member 30 is detachably connected to the transfer member 20 via the connection member 212 coupled to the second fastening hole 211 formed at the center of the piston body 21, thereby transferring the pressure.

In the foregoing transfer member 20 according to an embodiment of the present invention, the materials for the first contact ring 23a, the second contact ring 23b, the first guide ring 24a, and the second guide ring 24b to be in contact with the inner circumferential surface of the storage space 11 of the container body 10 may be selected, or combination of the number of contact rings and the number of guide rings may be selected in accordance with the properties of the evaporation material M, so that one apparatus can be used to supply the evaporation material M of various properties. Further, even though one of the elements is worn away due to repetitive use, only a relevant element is replaceable, thereby reducing maintenance costs.

Particularly, in the case that the evaporation material M such as copper (Cu), gallium (Ga), indium (In), selenium (Se) and the like materials used in a CIGS thin film solar cell is transferred at high temperature and high pressure, it is possible to select and apply a substance proper to the corresponding material, thereby improving durability.

Also, the first contact ring 23a, the second contact ring 23b, the first guide ring 24a, and the second guide ring 24b are spaced apart from one another and in contact with the inner circumferential surface of the storage space 11 of the container body 10, thereby showing a sufficient shielding effect and facilitating separation from the storage space 11 of the container body 10 for maintenance after process.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

### [Industrial Applicability]

According to an exemplary embodiment, there is provided a source material supplying unit for a thin film depositing apparatus, in which two or more contact rings are in contact with an inner wall surface of a container body, so that a shielding effect can be improved and the position and number of such contact rings can be selectively adjusted, thereby extending an applicable range of the apparatus in accordance with characteristics of the evaporation member.

## Claims

1. A source material supplying unit for a thin film depositing apparatus, arranged in a chamber for the thin film deposition apparatus and supplying an evaporation material to an injector for injecting the evaporation material, the source material supplying unit comprising:
a container body which is internally formed with a storage space where the evaporation material is stored, and comprises a discharging hole formed at one side thereof connected to the injector via a connection line;
a transfer member which comprises a piston body inserted in the storage space of the container body movably along a straight line, two or more seating members formed with a seating portion on an outer circumferential surface and arranged on an outside surface of the piston body, and at least two contact rings assembled to the seating portion of the seating member and closely contacting the inner circumferential surface of the storage space of the container body; and
a pressing member which applies pressure to the transfer member so that the transfer member can move toward the discharging hole of the container body.

2. The source material supplying unit for the thin film depositing apparatus according to claim 1, wherein the transfer member further comprises a guide ring arranged between the two contact rings and keeping a gap between the contact rings.

3. The source material supplying unit for the thin film depositing apparatus according to claim 2, wherein the guide ring is assembled to the seating portion of the seating member additionally arranged between the seating members to which the two contact rings are assembled.

4. The source material supplying unit for the thin film depositing apparatus according to claim 3, wherein the seating member comprises the seating portion on the upper end portion of the outer circumferential surface, and a holding projection protruding from the lower end portion of the outer circumferential surface.

5. The source material supplying unit for the thin film depositing apparatus according to claim 4, wherein the bottommost seating member among the two or more seating members arranged on an outside surface of the piston body is fastened to the piston body.

6. The source material supplying unit for the thin film depositing apparatus according to claim 5, wherein the transfer member further comprises a fastening member penetrating the two or more seating members and fastened to the piston body.

7. The source material supplying unit for the thin film depositing apparatus according to claim 6, wherein the transfer member further comprises a cover ring formed with a plurality of through holes on a surface thereof which the fastening member penetrates, and arranged above the topmost seating member among the two or more seating members

8. The source material supplying unit for the thin film depositing apparatus according to claim 7, wherein the transfer member further comprises a connection member arranged in a central upside of the piston body and detachably coupling with the pressing member.
